# FASCICULE DE BREVET EUROPEEN

(11) **EP 1 953 823 B1**
(45) Date de publication et mention de la délivrance du brevet: **12.10.2011**
(21) Numéro de dépôt: 08100848.4
(22) Date de dépôt: 23.01.2008
(51) Int. Cl.: H01L 27/02

(54) **Protection des circuits électroniques intégrés contre les décharges électrostatiques**
ESD-Schutz für Integrierte Schaltungen
ESD protection for integrated circuits

(30) Priorité: 31.01.2007 FR 0700688
(43) Date de publication de la demande: 06.08.2008
(73) Titulaire: STMICROELECTRONICS SA, 92120 Montrouge (FR)
(72) Inventeur: Galy, Philippe, 92700, COLOMBES (FR); Micheli, Laurent, 38450, VIF (FR); Troussier, Ghislain, 38920, CROLLES (FR); Rien, Mikael, 38330, BIVIERS (FR); Venient, Jean-Francois, 38700, LA TRONCHE (FR)
(74) Mandataire: Cabinet Plasseraud

(56) Documents cités:
- JP-A- 2000 151 382
- JAESIK LEE ET AL: "Chip-Level Charged-Device Modeling and Simulation in CMOS Integrated Circuits" IEEE TRANSACTIONS ON COMPUTER AIDED DESIGN OF INTEGRATED CIRCUITS AND SYSTEMS, IEEE SERVICE CENTER, PISCATAWAY, NJ, US, vol. 22, no. 1, janvier 2003 (2003-01), XP011070681 ISSN: 0278-0070
- BRENNAN ET AL: "ESD design automation & methodology to prevent CDM failures in 130 & 90nm ASIC design systems" JOURNAL OF ELECTROSTATICS, ELSEVIER SCIENCE PUBLISHERS B.V. AMSTERDAM, NL, vol. 64, no. 2, février 2006 (2006-02), pages 112-127, XP005194563 ISSN: 0304-3886
- YOON HUH ET AL: "ESD-Induced Internal Core Device Failure: New Failure Modes in System-on-Chip (SoC) Designs, invited" SYSTEM-ON-CHIP FOR REAL-TIME APPLICATIONS, 2005. PROCEEDINGS. FIFTH INTERNATIONAL WORKSHOP ON BANFF, AB, CANADA 20-24 JULY 2005, PISCATAWAY, NJ, USA,IEEE, 20 juillet 2005 (2005-07-20), pages 47-53, XP010851913 ISBN: 0-7695-2403-6
- VOLDMAN H: "ESD RF Technology and Circuits passage" ESD RF TECHNOLOGY AND CIRCUITS, WILEY,, US, 1 septembre 2006 (2006-09-01), pages 100-101, XP002456302

## Description

La présente invention concerne la protection des circuits électroniques intégrés contre les ESD ("Electrostatic Discharge").

Elle se rapporte de manière générale à la conception de circuits électroniques intégrés, et plus particulièrement aux tests d'aide à la conception de circuits dont notamment les tests de tenue aux ESD.

Ces tests visent à évaluer la robustesse des circuits électroniques intégrés lorsqu'ils sont soumis à des décharges électrostatiques, et à trouver des règles de conception limitant les contraintes liées à ces décharges électrostatiques.

Pour qualifier la tenue des circuits électroniques intégrés aux décharges électrostatiques, on dispose de modèles normalisés représentant l'environnement hostile dans lequel évoluent ces circuits, et qui sont notamment utilisés lors de phase de test pour l'aide à la conception des circuits électroniques.

Les décharges électrostatiques peuvent ainsi être modélisées par le modèle du composant chargé ou CDM ("Charged Device Model"). Le CDM est un modèle normalisé qui présente la particularité, par rapports à d'autres modèles connus par ailleurs, de représenter la décharge propre d'un circuit électronique intégré assemblé dans un boîtier. Il permet donc de prendre en compte l'effet du boîtier dans lequel le circuit électronique est agencé, en termes de tenue aux ESD. On notera que, dans ce contexte, le boîtier est défini par, notamment, le matériau d'enrobage, les broches d'interconnexions, les fils du câblage, l'embase ou substrat, la colle et bien sûr la puce en silicium.

On parle de tests CDM, pour désigner les tests de tenue aux ESD des circuits électroniques intégrés qui sont basés sur le modèle CDM.

Les tests CDM, en soi, posent un problème de fiabilité des circuits électroniques intégrés, lequel est accentué par la réduction des dimensions caractéristiques des transistors MOS et l'augmentation corrélative du niveau d'intégration. En effet, lors d'un test CDM, le circuit subit des contraintes électriques, aussi appelées stress CDM, sous la forme de courants de plusieurs ampères durant quelques nanosecondes, avec des temps de montée de quelques dizaines de picosecondes. Ce stress CDM peut conduire à l'endommagement du circuit. Le stress CDM peut notamment se traduire par des courts-circuits ou inversement des circuits ouverts dans les couches d'oxyde de grille des transistors MOS, par d'autres dégradations irréversibles, et par des courants de fuite.

Dans l'art antérieur, la protection des circuits électroniques intégrés est assurée au niveau de trois régions distinctes: les entrées, les sorties, et les alimentations. Des structures élémentaires de protection contre les ESD, optimisées pour chaque technologie, sont ainsi insérées sur le circuit intégré à protéger (on parle de protection "in situ") de manière à:
- lutter contre les décharges ESD positives et négatives;
- ne pas affecter la fonctionnalité du circuit en conditions normales de fonctionnement, c'est-à-dire lorsque le circuit est soumis à sa tension d'alimentation opérationnelle (on parle de mode "alimenté");
- écrêter les hautes tensions et évacuer le courant de décharge;
- occuper un minimum de place; et,
- ne pas induire d'étape supplémentaire dans le procédé de fabrication des composants.

Néanmoins, on constate que beaucoup de composants ne résistent pas aux phases de test de tenue aux ESD, en raison d'endommagements irréversibles qui proviennent du stress CDM.

De façon totalement indépendante des considérations liées au stress CDM, on sait par ailleurs réaliser des protections de lignes métalliques contre la charge qui se produit en phase de fabrication d'un circuit électronique du fait de l'exposition à un plasma. Une telle exposition est l'une des méthodes utilisées pour graver des métaux. Cette charge, connue sous le nom de "plasma charging", est à l'origine de défaillances ultérieures, et est perceptible pour des lignes dont la longueur excède plusieurs dizaines de microns. Compte tenu de leur longueur, de telles lignes sont, en généra!, des lignes d'antenne. Afin d'évacuer les charges accumulées sur ces lignes, on sait réaliser un élément de protection à base de diode(s), appelé "diode d'antenne". Un tel élément est disponible dans les bibliothèques de composants qui sont à la disposition des concepteurs de circuits électronique intégrés.

L'analyse décrite par le document JAESIK LEE ET AL: "Chip-Level Charged Device Modeling and Simulation in CMOS Integrated Circuits" IEEE TRANSACTIONS ON COMPUTER AIDED DESIGN 0F INTEGRATED CIRCUITS AND SYSTEMS, IEEE SERVICE CENTER,PISCATAWAY, NJ, US, vol. 22, no. 1, janvier 2003 (section « CDM Macromodel for Subsystem ») considère les effets des charges accumulées dans les noeuds internes comme négligeables à cause des faibles capacités associées à ces noeuds, qui limitent en fait la possibilité d'accumulation de charges pendant les tests CDM en comparaison avec celles qui peuvent être accumulées sur les lignes métalliques d'alimentation ou les plans de masse.

Le document BRENNAN ET AL: "ESD design automation & methodology to prevent CDM failures in 130 & 9Onm ASIC design systems" JOURNAL 0F ELECTROSTATICS, ELSEVIER SCIENCE PUBLISHERS B.V. AMSTERDAM, NL, vol. 64, no. 2, février (2006-02), pages 112-127 (voir paragraphe 2.3.1) décrit des dommages causés à certains noeuds internes, Il en identifie les causes dans la configuration du circuit mais il ne propose pas l'introduction d'éléments de protection.

Les documents YOON HUH ET AL: "ESD-Induced Internal Core Device Failure: New Failure Modes in System-on-Chip (SOC) Designs, invited" SYSTEM-ON-CHIP FOR REAL-TIME APPLICATIONS, 2005. PROCEEDINGS. FIFTH INTERNATIONAL WORKSHOP ON BANFF, AB, CANADA 20-24 JULY 2005, PISCATAWAY, NJ, USA,IEEE, 20 juillet 2005 (2005-07-20), pages 47-53; et VOLDMAN H: "ESD RF Technology and Circuits passage" ESD RF TECHNOLOGY AND CIRCUITS, WILEY" US, 1 septembre 2006 (2006-09-01), pages 100-101, décrivent des dommages causés à certains noeuds internes identifiées comme étant sensibles aux dommages ESD et proposent l'introduction d'éléments de protection.

Un objet de la présente invention est donc d'améliorer encore la protection des circuits électroniques contre le stress CDM, c'est-à-dire contre les contraintes électriques appliquées pendant un test CDM.

A cet effet, l'invention propose un circuit électronique intégré selon la revendication 1.

L'invention part de l'observation, qui a été faite par les inventeurs, que les charges qui traversent le circuit électronique lors d'un test CDM sont des charges induites par des impulsions CDM dans les deux polarités, positive et négative, et que la topologie des circuits à fort taux d'intégration actuels donne des situations dans lesquelles des noeuds de circuit ne sont pas associés à des chemins de conduction électrique permettant la décharge des charges de chacune des polarités. En effet, des noeuds du circuit électronique sont susceptibles de se comporter comme de véritables condensateurs. Des noeuds peuvent en effet être le siège d'une accumulation de charges positives (trous e+) ou de charges négatives (électrons e-) qui élève, respectivement abaisse, le potentiel électrique sur ces noeuds.

Lorsqu'il existe un chemin de décharge permettant d'évacuer les charges de chacune des polarités vers des rails d'alimentation respectifs, tout se passe bien. Mais quand, en raison de la topologie du circuit électronique, il existe des noeuds à partir desquels les charges positives ou les charges négatives accumulées ne peuvent pas être évacuées, il se produit localement des différences de potentiel importantes avec des zones voisines du circuit, susceptibles de produire des claquages. Des différences de potentiel peuvent ainsi être à l'origine des endommagements constatés en pratique. Dans la suite, on parle d'îlots capacitifs pour désigner de tels noeuds. De tels îlots capacitifs se rencontrent, par exemple, au niveau du noeud commun entre le drain et la source de deux transistors MOS de la même famille (soit des NMOS, soit des PMOS) cascadés.

Selon le constat fait par les inventeurs, ces îlots capacitifs expliquent la fragilité du circuit électronique intégré vis-à-vis du stress CDM, les différences de potentiel évoquées ci-dessus conduisant à des phénomènes de claquage de zones diélectriques et de jonctions dans les circuits électroniques intégrés. L'invention permet d'éviter cette fragilité, dans la mesure où elle permet la décharge, pendant un test CDM, des charges de chaque polarité accumulées sur n'importe quel îlot capacitif qui est identifié comme tel en fonction de la topologie du circuit électronique intégré, en prévoyant un chemin de décharge à partir de cet îlot.

Avantageusement, les moyens de protection ajoutés au circuit électronique pour assurer la protection des îlots capacitifs contre la surcharge, ne modifient pas le fonctionnement normal du circuit en mode actif, c'est-à-dire lorsqu'il est mis sous une tension d'alimentation. En effet, l'élément de conduction unidirectionnelle est alors polarisé en inverse en sorte que le moyen de protection se comporte comme un circuit ouvert.

On notera que les éléments de protection du type "diode d'antenne", évoqués en introduction, peuvent se trouver, fortuitement, associés à des ilots capacitifs au sens de la présente description. Ces éléments, qui sont par ailleurs prévus dans un tout autre but, peuvent donc fortuitement remplir la fonction des éléments de protection au sens de la présente description. Néanmoins, ces "diodes d'antenne" ne sont prévues que pour la protection contre les charges accumulées avec une seule polarité. Il s'ensuit que, même fortuitement, ils ne protégeraient de toute façon le circuit qui en serait doté que contre une partie seulement du stress CDM.

L'invention concerne également un procédé d'aide à la conception d'un circuit électronique intégré selon la revendication 7.;

Les étapes d'identification, au moins, peuvent être mises en oeuvre par un ordinateur correctement programmé. L'ajout des éléments de protection peut aussi être réalisé de manière automatique, sous la commande du programme. Le procédé peut ainsi être mis en oeuvre partiellement ou en totalité, dans les logiciels d'aide à la conception de circuit, ou CAD en anglais ("Computer-aided Design").

D'autres caractéristiques et avantages de l'invention apparaîtront encore à la lecture de la description qui va suivre. Celle-ci est purement illustrative et doit être lue en regard des dessins annexés sur lesquels :
- la figure 1 est une représentation schématique d'un appareil de test CDM;
- la figure 2 est un schéma illustrant symboliquement le phénomène de décharge électrostatique qui se produit lors d'une opération de test CDM;
- la figure 3 est un schéma électrique simplifié permettant de modéliser le phénomène de décharge ;
- la figure 4 donne les courbes de réponse en tension et en courant pour une impulsion CDM positive ;
- la figure 5 donne les courbes de réponse en tension et en courant pour une impulsion CDM négative ;
- la figure 6 est une représentation schématique d'une portion d'un circuit électronique qui n'est pas un îlot capacitif au sens de la présente description ;
- la figure 7 est une représentation schématique d'une portion d'un circuit électronique qui, au contraire, est un îlot capacitif au sens de la présente description ;
- la figure 8 est une représentation schématique d'une portion d'un circuit électronique qui comprend un îlot capacitif d'un premier type et un élément de protection, ainsi qu'un îlot capacitif d'un second type et un élément de protection.

Au contraire des modèles de test de tenue aux ESD classiques, dans lesquels la décharge électrostatique modélisée vient de l'appareil de test et va vers le circuit intégré sous test, le modèle du circuit chargé ou CDM représente la décharge propre d'un circuit intégré. Il arrive en effet que les composants se chargent par triboélectricité, en sorte que la constitution des composants (boîtiers, taille de la puce et capacités internes) est ainsi idéalement prise en compte dans le CDM.

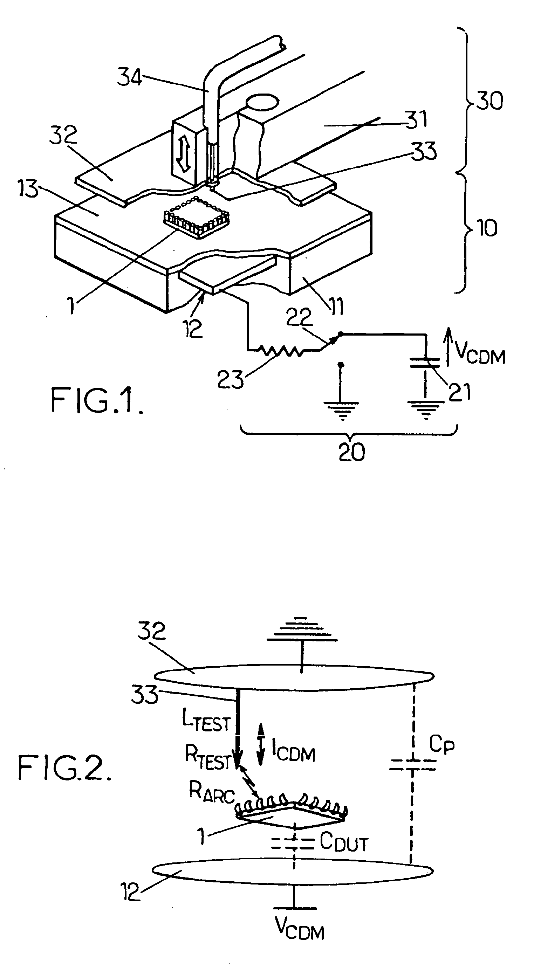

En référence à la figure 1, un appareil de test FCDM ("Field CDM") comprend un ensemble de charge 10 fixe, auquel un dispositif de charge 20 est couplé, ainsi qu'un ensemble de décharge 30 mobile par rapport à l'ensemble de charge.

L'ensemble de charge 10 comprend un support 11, un plateau formant électrode de charge 12, recouvert par un isolant 13 ("FR-4"), l'électrode 12 et l'isolant 13 étant solidaires du support 11.

Le dispositif de charge 20 comprend une source de haute tension 21 qui délivre une haute tension CDM, notée V_{CDM} dans la suite et aux figures. Typiquement, la tension V_{CDM} est de l'ordre de 500 V environ à 1 kV environ. Cette tension peut être négative ou positive. La source de haute tension 21 peut être couplée sélectivement, c'est-à-dire de façon commandée via un interrupteur 22, à l'électrode de charge 12 à travers une résistance de charge 23, dont la valeur de résistance est notée R_{CHRG} dans la suite et aux figures. Typiquement, la résistance R_{CHRG} est de l'ordre de 500 MΩ environ à 1 GΩ environ.

L'ensemble de décharge comprend un bras 31 formant support mobile, un plateau formant électrode de décharge 32, mis à la masse, ainsi qu'une sonde de décharge 33 ("POGO Probe"). Le plateau 32 et la sonde 33 sont solidaires du bras 31. Celui-ci est mobile et peut être commandé de manière que la sonde 33 soit déplacée dans un plan parallèle au plan de l'ensemble de charge 10, et verticalement par rapport à celui-ci. La sonde 33 est couplée à un appareil d'enregistrement et de visualisation (non représenté) par l'intermédiaire d'un câble isolé 34 tel qu'un câble coaxial. L'âme du câble coaxial est couplée à la sonde 33, et au plateau 32 par l'intermédiaire d'une résistance radiale de très faible valeur, notée R_{TEST} dans la suite et aux figures. Typiquement la résistance R_{TEST} est égale à 1 Ω environ.

En fonctionnement, le plateau 32 vient sensiblement au droit de l'électrode de charge 12. Les dimensions de l'électrode de charge 12 et du plateau de décharge 32 sont sensiblement identiques, et très supérieures à celles des circuits intégrés à tester.

En référence en outre au schéma de la figure 2, le principe du test FCDM ("Field CDM") est le suivant. Le circuit intégré 1 sous test, ou DUT ("Device Under Test") est posé pattes en l'air ("dead-bug") au dessus de l'ensemble de charge. Le dispositif de charge est commandé de manière que la tension V_{CDM} soit appliquée au plateau de charge 12. Le circuit 1 se charge alors à cette tension, par convection du charges (et pas par conduction de charges). On note C_{DUT} la charge accumulée dans le circuit 1. Puis le bras 31 de l'ensemble de décharge est commandé de manière que la sonde 33 contacte l'une des pattes du circuit 1. En fait, même avant que le contact se produise, il se produit un arc entre l'extrémité de la sonde 33, qui est au potentiel de la masse, et le circuit 1. On note R_{ARC} la valeur de la résistance de cet arc électrique. Par cet arc électrique, puis par conduction après que le contact soit effectivement réalisé, un courant de décharge noté I_{CDM} s'écoule du circuit 1 vers l'électrode de décharge 32 à travers la sonde 33 et la résistance radiale R_{TEST} évoquée supra. On note L_{TEST} la valeur d'inductance propre de la sonde 33.

Il se produit alors, brutalement, une décharge entre le circuit 1 et la masse, vers le plateau de décharge 32 (lorsque la tension V_{CDM} est positive) ou à partir de ce plateau (lorsque la tension V_{CDM} est négative). Cette décharge brutale se traduit par un courant I_{CDM}. La source de l'impulsion est alors constituée par le dispositif lui-même, et le rôle du boîtier du circuit 1 sous test est pris en compte.

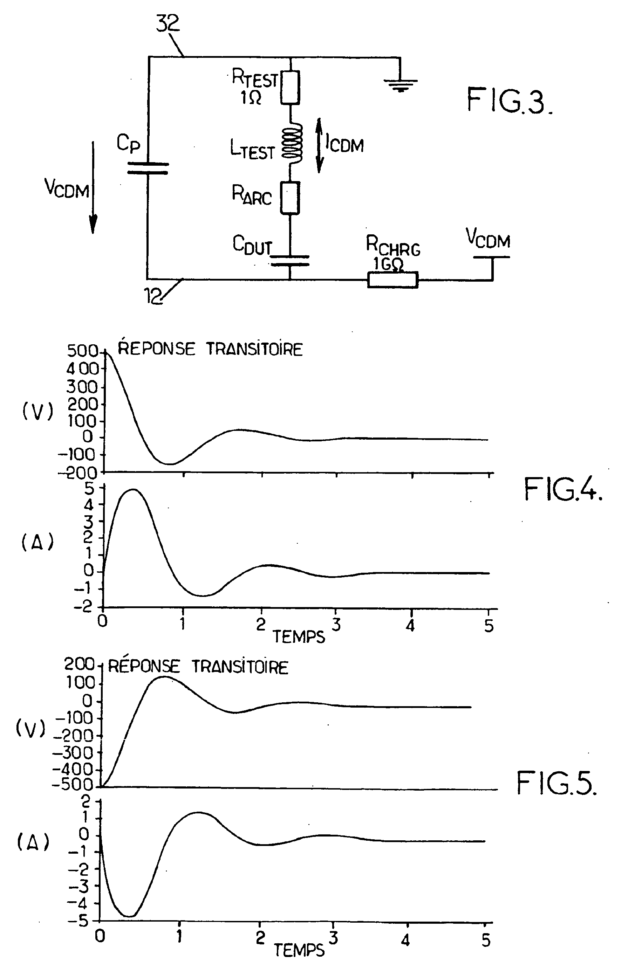

Le schéma électrique équivalent est donné à la figure 3, sur laquelle, en outre, on note C_{P} la valeur du condensateur formé par les deux plateaux 12 et 32. Comme on le voit, le schéma électrique équivalent est celui d'un circuit oscillant de type RLC. La réponse d'un tel circuit à une excitation de type impulsionnelle, à laquelle la décharge correspond, est la réponse d'un circuit électrique amorti.

Les courbes des figures 4 et 5 donnent chacune l'allure de la tension (courbe du dessus) et du courant (courbe du dessous) prélevés au niveau de la sonde 33, pour une tension CDM de +500 V et pour une tension CDM de -500 V, respectivement.

En pratique, le même test est réalisé pour toutes les pattes du circuit sous test, successivement. L'analyse des formes d'onde recueillies, et l'analyse du fonctionnement du circuit avec les tests, permettent de qualifier la tenue du circuit aux ESD.

On notera que, dans le cas d'un appareil de test FCDM tel qu'envisagé dans l'exemple ci-dessus, le circuit est chargé par un champ électrique, mais qu'il existe des appareils de test CCDM (« Contact CDM ») dans lesquels le circuit est chargé par contact.

De même, dans l'exemple d'un appareil décrit ci-dessus en référence à la figure 1, le composant sous test est placé pattes en l'air sur une électrode de charge, mais, en variante, il peut être inséré dans un support de test ou SCDM ("Socketed CDM").

Le principe de l'invention est indépendant des modalités de réalisation du test CDM, étant donné que celles-ci n'influent pas sur les phénomènes électriques observés lors de la décharge électrostatique.

Un circuit électronique intégré comprend un assemblage de composants formant un réseau de noeuds de circuit reliés par des branches de circuit.

On notera que, pendant le test CDM, le circuit sous test n'est pas soumis à sa tension d'alimentation opérationnelle. On parle ici de mode "non alimenté". Dans ce mode non alimenté, les différents noeuds du circuit électronique sont flottants, car, en l'absence de tension d'alimentation, ils ne sont pas polarisés. Lors des décharges électrostatiques positives ou négatives, les branches de circuit peuvent toutefois, selon la topologie du circuit, être traversées par des courants de charges positives ou négatives selon la polarité de l'impulsion CDM créée. Par conséquent, les noeuds du circuit se chargent soit positivement soit négativement, respectivement, en fonction des courants d'origine électrostatique qui circulent par conduction dans le circuit, et ce pour autant que la topologie du circuit leur offre des chemins de charge associés.

Il a été observé que, en raison la topologie du circuit électronique résultant de la fonction recherchée pour laquelle ce circuit a été conçu, il peut exister des noeuds pour lesquels il existe au moins un chemin de charge pour la charge avec des charges positives ou négatives, mais pas de chemin de décharge correspondant à ces charges. Dans la présente description, l'expression "ilot capacitif" est utilisée en référence à de tels noeuds.

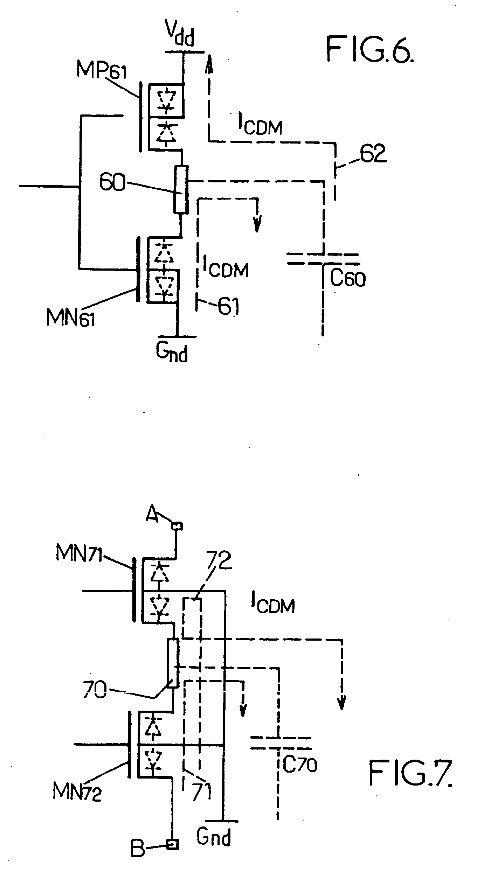

Il existe aussi des zones auxquelles sont associées à la fois un chemin de décharge pour les charges positives et un chemin de décharge pour les charges négatives. Ainsi, en référence au schéma de la figure 6, le drain commun 60 entre un transistor MOS de type P (PMOS), référencé MP61, et un transistor MOS de type N (NMOS), référencé MN61, d'un inverseur CMOS disposé entre un potentiel d'alimentation Vdd et la masse Gnd, ne forme pas un ilot capacitif au sens de la présente description. Certes ce noeud peut, comme tout noeud d'un circuit électronique, être assimilé à une capacité C60 (représentée en traits pointillés) entre le noeud en question et son environnement et être chargé positivement ou négativement.

Néanmoins, il existe un chemin de décharge 61 des charges positives à partir de ce noeud 60 vers la masse Gnd, passant par la diode substrat-drain parasite du transistor MN61 (les diodes parasites des transistors MN61 et MP61 sont représentées en traits pointillés également), la zone de substrat ("bulk" ou "dye") du transistor MN61 étant couplée à la masse Gnd. Et il existe par ailleurs un chemin de décharge 62 des charges négatives à partir de ce noeud 60 vers la borne Vdd, passant par la diode drain-substrat parasite du transistor MN61, la zone de substrat du transistor MN61 étant couplée à la borne d'alimentation Vdd. Ces chemins de décharge 61 et 62 sont représentés en traits pointillés à la figure 6. Ils permettent l'écoulement d'un courant de décharge, noté I_{CDM} dans les deux cas, lors d'un test CDM.

On notera aussi que les chemins de décharge 61 et 62 agissent, par nature, même en l'absence de tension d'alimentation appliquée au circuit, c'est-à-dire en mode non alimenté (mode dans lequel se trouve le circuit pendant un test CDM). Les charges positives aussi bien que les charges négatives qui peuvent atteindre le noeud 60 lors d'une décharge électrostatique telle que celles créées lors d'un test CDM, sont donc évacuées vers la masse ou vers la borne Vdd, respectivement, et ne sont donc pas accumulées au niveau du noeud 60. C'est en ce sens qu'on dit que le noeud 60 n'est pas un ilot capacitif, au sens de la présente description. Les charges ainsi "évacuées" du noeud 60 vers les bornes d'alimentation sont ensuite traitées localement par les éléments de protection prévus sur ces bornes ainsi qu'il est connu par ailleurs.

Un exemple d'ilot capacitif va maintenant être exposé en référence au schéma de la figure 7.

Sur cette figure, on a représenté une portion d'un circuit électronique qui correspond à une paire de transistors MOS cascadés. Il s'agit ici de deux NMOS, référencés MN71 et MN72, disposés en série entre un noeud A et un noeud B du circuit. Plus exactement, le drain de MN71 est relié au noeud A, la source de MN72 est reliée au noeud B, alors que la source de MN71 et le drain de MN72 sont reliés à un noeud commun 70. Comme il est classique, les zones de substrat des NMOS MN71 et MN72 sont reliées à la masse Gnd.

Comme on va le voir maintenant, le noeud 70 est un ilot capacitif au sens de la présente description. Bien entendu, la description qui va suivre vaut également pour le cas (non représenté) d'une paire de transistors PMOS cascadés, dont le noeud commun est aussi (pour des raisons symétriques) un ilot capacitif.

A la figure 7, on note C70 la capacité équivalente du noeud 70. En mode non alimenté, il existe un premier et un second chemins de décharge du noeud 70 vers la masse, référencés respectivement 71 et 72. Le chemin 71 part de la masse (à laquelle la source et le substrat de MN72 sont reliés) et traverse la diode parasite substrat-drain de MN72. C'est un chemin de décharge des charges positives. Le second chemin 72 part aussi de la masse (à laquelle le substrat de MN71 est relié) et traverse la diode source-grille de MN71. C'est aussi un chemin de décharge des charges positives.

Par contre, il n'existe pas de chemin de décharge des charges négatives. En effet, la diode source-substrat parasite de MN71 et la diode substrat-drain parasite de MN72 s'opposent au passage des charges négatives vers la borne Vdd à partir du noeud 70. Par conséquent, de telles charges peuvent s'y accumuler lors d'une ESD et notamment lors d'un test CDM, d'où il résulte une chute de potentiel occasionnant les dommages qui ont été mentionnés en introduction lorsqu'elle dépasse une valeur critique.

Ainsi qu'on l'a compris, pour d'autres noeuds du circuit, par exemple le noeud commun entre deux transistors PMOS cascadés, c'est l'inverse. Il existe au moins un chemin de décharge des charges négatives, mais pas de chemin de décharge des charges positives. Les phénomènes électriques sont symétriques, avec pour même conséquence que le circuit peut être endommagé par les ESD, notamment lors d'un test CDM.

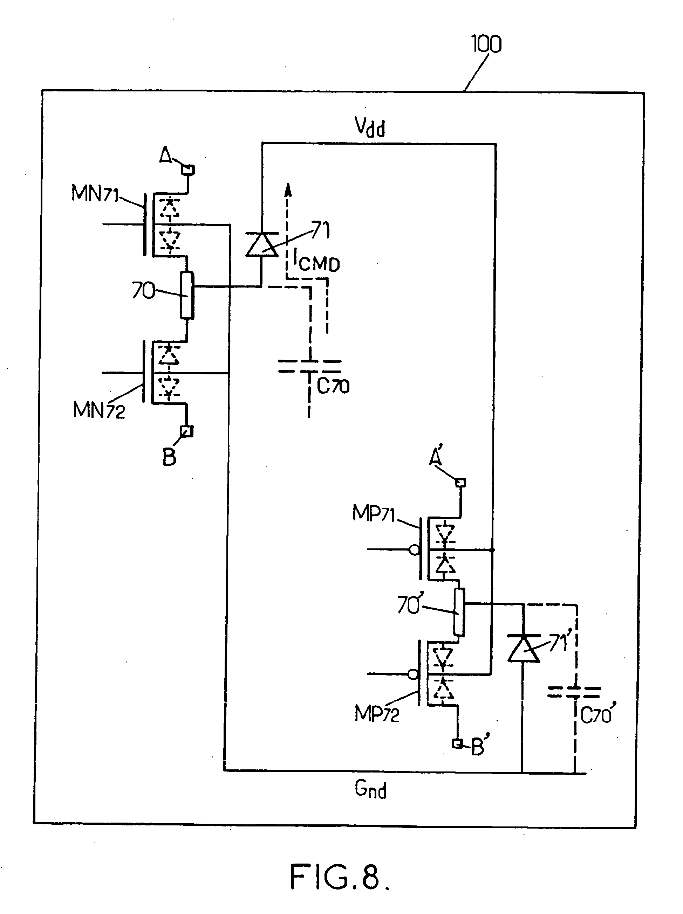

Une solution globale à ce problème va maintenant être décrite, en référence à la figure 8. Sur cette figure, on a représenté deux portions d'un même circuit électronique 100.

La première portion, en haut à gauche, correspond à la portion de circuit décrite ci-dessus en regard de la figure 7. Elle est reproduite avec les mêmes signes de référence et ne sera pas décrite à nouveau ici. Il s'agit d'une portion de circuit comprenant un noeud (à savoir l'ilot capacitif 70) d'un premier type, en ce sens qu'il possède au moins un chemin de décharge des charges positives, mais pas de chemin de décharge des charges négatives. Les zones de substrat des NMOS sont reliées à la masse Gnd.

La seconde portion, en bas à droite, correspond au cas symétrique de la portion de circuit décrite ci-dessus en regard de la figure 7, puisqu'il s'agit d'une paire de transistors PMOS cascadés entre un noeud A' et un noeud B'. On note MP71 et MP72 ces deux PMOS, et on note 70' le noeud commun entre ces deux transistors. De même, on note C70' la capacité équivalente du noeud 70' (représentée en traits pointillés). Il s'agit d'une portion de circuit comprenant un noeud (à savoir l'ilot capacitif 70') d'un second type, en ce sens qu'il possède au moins un chemin de décharge des charges négatives, mais pas de chemin de décharge des charges positives. Les zones de substrat des PMOS sont reliées à la borne d'alimentation positive Vdd.

Selon des modes de réalisation de l'invention, on prévoit au moins un élément de protection 71 de l'ilot capacitif 70 (élément de protection d'un premier type), et au moins un élément de protection 71' de l'ilot capacitif 70' (élément de protection d'un second type).

Dans un mode de réalisation, l'un et/ou l'autre des éléments de protection 71 et 71' est une diode. De préférence, il s'agit d'une diode du type dit "diode d'antenne" car c'est généralement la diode la plus petite (c'est-à-dire celle qui occupe le moins de surface de silicium) qui soit disponible dans les bibliothèques de composants à la disposition du concepteur de circuits.

La diode 71, qui est un élément dit du premier type car protégeant le noeud 70, est couplée à celui-ci par son anode et à la borne d'alimentation positive Vdd par sa cathode. Ainsi, elle crée dans le mode non alimenté un chemin de décharge des charges négatives depuis le noeud 71 vers la borne Vdd. Ce chemin n'a aucune influence sur le fonctionnement du circuit en mode alimenté. En effet, dès lors qu'une tension d'alimentation positive est appliquée sur la borne Vdd, la diode 71 est polarisée en inverse, en sorte qu'aucun courant ne circule à travers elle.

Symétriquement, la diode 71', qui est un élément dit du second type car protégeant le noeud 70', est couplée à celui-ci par sa cathode et à la borne de masse Gnd par son anode. Ainsi, elle crée en mode non alimenté un chemin de décharge des charges positives depuis le noeud 71' vers la masse. Ce chemin n'a aucune influence sur le fonctionnement du circuit en mode alimenté. En effet, dès lors qu'une tension d'alimentation positive est appliquée sur la borne Vdd, la diode 71' est polarisée en inverse, en sorte qu'aucun courant ne circule à travers elle.

En variante, l'un et/ou l'autre des éléments de protection 71 et 71' est un transistor ggNMOS ("Grounded Gate MOS"). Un tel transistor occupe plus de surface de silicium qu'une simple diode mais peut permettre d'évacuer un courant plus important. Les noeuds à protéger 70 et 70', sont alors reliés au drain du transistor ggNMOS tandis que la grille, la source et le substrat de ce transistor sont connectés ensembles à la borne de masse Gnd. De cette manière, le composant est bloqué lors d'une utilisation normale du circuit intégré, en mode alimenté, en sorte qu'il n'affecte pas le fonctionnement du circuit dans ce mode. Il ne modifie pas la fonctionnalité du circuit.

En variante encore, l'élément de protection 71 peut être un transistor PMOS dont la grille, la source et le substrat sont connectés à la borne d'alimentation Vdd et dont le drain est couplé au noeud 70 à protéger.

L'élément de protection 71' peut être un thyristor agencé pour permettre la décharge des charges positives vers la masse Gnd.

Dans d'autres variantes, les éléments de protection peuvent être encore différents, ou être réalisés à partir d'un assemblage des composants déjà cités, éventuellement combinés à d'autres composants.

Bien entendu, les exemples de portions de circuit donnés plus haut ne sont pas limitatifs. Il existe d'autres topologies de circuits dans lesquelles le même problème se rencontre et peut être pallié de la même manière. Par exemple, le noeud commun entre deux condensateurs mis en série peut, dans certains cas, être chargé (soit positivement soit négativement), ou le noeud central d'une paire différentielle et de son transistor de polarisation qui est de la même famille. C'est le concepteur du circuit qui, à partir de la compréhension du fonctionnement du circuit en mode non alimenté, détermine les noeuds à protéger. Des outils d'aide à la conception de circuit peuvent aussi être programmés pour assister le concepteur de circuit dans cette tâche.

On notera qu'un même élément de protection, quelque soit son type et son mode de réalisation, peut éventuellement protéger deux ilots capacitifs différents du même circuit. On veillera seulement à ce qu'il soit adapté pour supporter les courants qu'il est susceptible de devoir ainsi évacuer.

A l'inverse, si un élément de protection qu'on souhaite utiliser n'est pas capable de supporter un tel courant, on peut dupliquer l'élément autant de fois que nécessaire.

On notera que les noeuds à protéger 70 et 70' peuvent être situés au coeur du circuit, en ce sens qu'il ne s'agit pas forcément de noeuds correspondant à des bornes d'entrée/sortie du circuit, ni à fortiori de bornes d'alimentation. Ils peuvent correspondre à de telles bornes, mais ils peuvent aussi être des noeuds bien enfouis dans l'intimité du circuit et être totalement inaccessibles depuis l'extérieur du circuit.

La borne de masse peut être remplacée par une borne d'alimentation négative, pour les circuits à alimentation différentielle. De même, il peut y avoir plusieurs tensions d'alimentation opérationnelles de valeurs respectives distinctes. Dans tous les cas l'enseignement de l'invention s'applique de façon générale, de la même façon que précédemment décrit, pour des circuits agencés entre une borne d'alimentation haute et une borne d'alimentation basse, ce qui précède s'appliquant mutatis mutandis pour ces bornes d'alimentation haute et basse à la place de la borne Vdd et de la borne Gnd, respectivement.

De même, les noeuds A et B, et A' et B' peuvent être des bornes d'alimentation ou des bornes d'entrée/sortie, mais peuvent aussi être des noeuds fonctionnellement enfouis au coeur de l'architecture du circuit.

L'invention est avantageusement mise en oeuvre dès la phase de conception du circuit. Le concepteur du circuit analyse la topologie du circuit pour comprendre son fonctionnement en mode non alimenté lorsque des impulsions CDM lui sont appliquées. Il identifie les noeuds à protéger, et ajoute au schéma du circuit les éléments de protection correspondants. Ceci peut aussi être réalisé, partiellement ou en totalité, par un logiciel de CAD. Ainsi, l'invention peut servir de base au développement d'un nouveau module des logiciels de CAD.

## Revendications

1. Circuit électronique intégré (100) comprenant un assemblage de composants formant un réseau de noeuds de circuit reliés par des branches de circuits, dans lequel:
- au moins un premier noeud de circuit (70) est couplé à une ou plusieurs branches de circuit qui, lorsque le circuit électronique n'est pas soumis à une tension d'alimentation opérationnelle, ne permettent la décharge dudit premier noeud que pour des charges électriques d'une première polarité, positive ou négative, mais pas pour des charges électriques d'une seconde polarité, négative ou positive, respectivement; et,
- au moins un second noeud de circuit (70') est couplé à une ou plusieurs branches de circuit qui, lorsque le circuit électronique n'est pas soumis à la tension d'alimentation opérationnelle, ne permettent la décharge dudit second noeud que pour des charges électriques de la seconde polarité mais pas pour des charges électriques de la première polarité,
**caractérisé en ce qu'**il comprend en outre:
- un premier élément de protection (71) associé au premier noeud de circuit et qui est adapté pour, lorsque le circuit électronique n'est pas soumis à la tension d'alimentation opérationnelle, permettre la décharge dudit premier noeud de circuit pour des charges de la seconde polarité, et pour, lorsque le circuit électronique est soumis à la tension d'alimentation opérationnelle, ne pas permettre la circulation d'un courant électrique à travers ledit premier élément de protection; et,
- un second élément de protection (71') associé au second noeud de circuit et qui est adapté pour, lorsque le circuit électronique n'est pas soumis à la tension d'alimentation opérationnelle, permettre la déchargé dudit second noeud de circuit pour des charges de la première polarité, et pour, lorsque le circuit électronique est soumis à la tension d'alimentation opérationnelle, ne pas permettre la circulation d'un courant électrique à travers ledit second élément de protection.

2. Circuit électronique intégré selon la revendication 1, comprenant une borne d'alimentation haute (Vdd) et une borne d'alimentation basse (Gnd), et dans lequel le premier élément de protection comprend, pour la décharge de charges négatives, une diode dont l'anode est couplée au premier noeud de circuit et dont la cathode est couplée à la borne d'alimentation haute.

3. Circuit électronique intégré selon la revendication 1 ou la revendication 2, dans lequel le second élément de protection comprend, pour la décharge de charges négatives, une diode couplée par sa cathode au second noeud de circuit et par son anode à la borne d'alimentation basse.

4. Circuit électronique intégré selon la revendication 1, comprenant une borne d'alimentation haute (Vdd) et une borne d'alimentation basse (Gnd), dans lequel le premier élément de protection comprend, pour la décharge de charges négatives, un transistor PMOS dont le drain est couplé au premier noeud de circuit et dont la grille, la source et le substrat sont connectés à la borne d'alimentation haute.

5. Circuit électronique intégré selon la revendication 1, comprenant une borne d'alimentation haute (Vdd) et une borne d'alimentation basse (Gnd), dans lequel le second élément de protection comprend un thyristor pour la décharge de charges positives vers la borne d'alimentation basse.

6. Circuit électronique intégré selon l'une quelconque des revendications 1, 4 et 5, dans lequel le premier élément de protection et/ou le second élément de protection comprennent, pour la décharge de charges négatives, respectivement positives, un transistor ggNMOS dont le drain est couplé au premier noeud de circuit, respectivement au second noeud de circuit, et dont la grille, la source et le substrat sont connectés à la borne d'alimentation basse.

7. Procédé de conception d'un circuit électronique intégré comprenant un assemblage dé composants formant un réseau de noeuds de circuit reliés par des branches de circuit et destiné à avoir un fonctionnement déterminé lorsque le circuit électronique est soumis à une tension d'alimentation opérationnelle, **caractérisé en ce qu'**il comprend les étapes suivantes:
- identification d'au moins un premier noeud de circuit (70) couplé à une ou plusieurs branches de circuit qui, lorsque le circuit électronique n'est pas soumis à une tension d'alimentation opérationnelle, ne permettent la décharge dudit premier noeud que pour des charges électriques d'une première polarité, positive ou négative, mais pas pour des charges électriques d'une seconde polarité, négative ou positive, respectivement;
- identification d'au moins un second noeud de circuit (70') couplé à une ou plusieurs branches de circuit qui, lorsque le circuit électronique n'est pas soumis à la tension d'alimentation opérationnelle, ne permettent la décharge dudit second noeud que pour des charges électriques de la seconde polarité mais pas pour des charges électriques de la première polarité;
- ajout d'un premier élément de protection (71) associé au premier noeud de circuit et qui est adapté pour, lorsque le circuit électronique n'est pas soumis à la tension d'alimentation opérationnelle, permettre la décharge dudit premier noeud de circuit pour des charges de la seconde polarité, et pour, lorsque le circuit électronique est soumis à la tension d'alimentation opérationnelle, ne pas permettre la circulation d'un courant électrique à travers ledit premier élément de protection; et,
- ajout d'un second élément de protection (71') associé au second noeud de circuit et qui est adapté pour, lorsque le circuit électronique n'est pas soumis à la tension d'alimentation opérationnelle, permettre la décharge dudit second noeud de circuit pour des charges de la première polarité, et pour, lorsque le circuit électronique est soumis à la tension d'alimentation opérationnelle, ne pas permettre la circulation d'un courant électrique à travers ledit second élément de protection.

8. Procédé selon la revendication 7 dans lequel, le circuit électronique intégré comprenant une borne d'alimentation haute (Vdd) et une borne d'alimentation basse (Gnd), le premier élément de protection comprend, pour la décharge de charges négatives, une diode dont l'anode est couplée au premier noeud de circuit et dont la cathode est couplée à la borne d'alimentation haute.

9. Procédé selon la revendication 7 ou la revendication 8, dans lequel le second élément de protection comprend, pour la décharge de charges négatives, une diode couplée par sa cathode au second noeud de circuit et par son anode à la borne d'alimentation basse.

10. Procédé selon la revendication 7 dans lequel, le circuit électronique intégré comprenant une borne d'alimentation haute (Vdd) et une borne d'alimentation basse (Gnd), le premier élément de protection comprend, pour la décharge de charges négatives, un transistor PMOS dont le drain est couplé au premier noeud de circuit et dont la grille, la source et le substrat sont connectés à la borne d'alimentation haute.

11. Procédé selon la revendication 7 dans lequel, le circuit électronique intégré comprenant une borne d'alimentation haute (Vdd) et une borne d'alimentation basse (Gnd), le second élément de protection comprend un thyristor pour la décharge de charges positives vers la borne d'alimentation basse.

12. Procédé selon l'une quelconque des revendications 7, 8 et 9, dans lequel le premier élément de protection et/ou le second élément de protection comprennent, pour la décharge de charges négatives, respectivement de charges positives, un transistor ggNMOS dont le drain est couplé au premier noeud de circuit, respectivement au second noeud de circuit et dont la grille, la source et le substrat sont connectés à la borne d'alimentation basse.

## Claims

1. An integrated electronic circuit (100) comprising an assembly of components forming a network of circuit nodes connected by circuit branches, wherein:
- at least one first circuit node (70) is coupled to one or more circuit branches which, when the electrical circuit is not exposed to an operating voltage, only allow the discharge of said first node for electrical charges of a first polarity, positive or negative, but not for electrical charges of a second polarity, respectively negative or positive, and
- at least one second circuit node (70') is coupled to one or more circuit branches which, when the electronic circuit is not exposed to an operating voltage, only allow the discharge of said second node for electrical charges of the second polarity but not for electrical charges of the first polarity,
further comprising:
- a first protective element (71) associated with the first circuit node and which is adapted to allow the discharge of said first circuit node for charges of the second polarity, when the electronic circuit is not exposed to the operating voltage, and not to allow the flow of an electrical current to or from said first node when the electronic circuit is exposed to the operating voltage, and
- a second protective element (71') associated with the second circuit node and which is adapted to allow the discharge of said second circuit node for charges of the first polarity, when the electronic circuit is not exposed to the operating voltage, and not to allow the flow of an electrical current to or from said second node when the electronic circuit is exposed to the operating voltage.

2. An integrated electronic circuit according to claim 1, comprising a high voltage terminal (Vdd) and a low voltage terminal (Gnd), and wherein the first protective element comprises, for the discharge of negative charges, a diode whose anode is coupled to the first circuit node and whose cathode is coupled to the high voltage terminal.

3. An integrated electronic circuit according to claim 1 or claim 2, wherein the second protective element comprises, for the discharge of negative charges, a diode coupled by its cathode to the second circuit node and by its anode to the low voltage terminal.

4. An integrated electronic circuit according to claim 1, comprising a high voltage terminal (Vdd) and a low voltage terminal (Gnd), wherein the first protective element comprises, for the discharge of negative charges, a PMOS transistor whose drain is coupled to the first circuit node and whose gate, source and substrate are connected to the high voltage terminal.

5. An integrated electronic circuit according to claim 1, comprising a high voltage terminal (Vdd) and a low voltage terminal (Gnd), wherein the second protective element comprises a thyristor for the discharge of positive charges towards the low voltage terminal.

6. An integrated electronic circuit according to any of claims 1, 4 and 5, wherein the first protective element and/or the second protective element comprises, for the discharge of negative or positive charges respectively, a ggNMOS transistor whose drain is coupled to the first circuit node or the second circuit node respectively, and whose gate, source and substrate are connected to the low voltage terminal.

7. A process for designing an integrated electronic circuit comprising an assembly of components forming a network of circuit nodes connected by circuit branches and intended to have a determined operation when the electronic circuit is exposed to an operating voltage, with said process comprising the following steps:
- identification of at least one first circuit node (70) coupled to one or more circuit branches which, when the electronic circuit is not exposed to an operating voltage, only allow the discharge of said first node for electrical charges of a first polarity, positive or negative, but not for electrical charges of a second polarity, respectively negative or positive,
- identification of at least one second circuit node (70') coupled to one or more circuit branches which, when the electronic circuit is not exposed to the operating voltage, only allow the discharge of said second node for electrical charges of the second polarity but not for electrical charges of the first polarity,
- addition of a first protective element (71) associated with the first circuit node and which is adapted to allow the discharge of said first circuit node for charges of the second polarity, when the electronic circuit is not exposed to the operating voltage, and not to allow the flow of an electrical current to or from said first node when the electronic circuit is exposed to the operating voltage, and
- addition of a second protective element (71') associated with the second circuit node and which is adapted to allow the discharge of said second circuit node for charges of the first polarity, when the electronic circuit is not exposed to the operating voltage, and not to allow the flow of an electrical current to or from said second node when the electronic circuit is exposed to the operating voltage.

8. A process according to claim 7, wherein, the integrated electronic circuit comprising a high voltage terminal (Vdd) and a low voltage terminal (Gnd), the first protective element comprises, for the discharge of negative charges, a diode whose anode is coupled to the first circuit node and whose cathode is coupled to the high voltage terminal.

9. A process according to claim 7 or claim 8, wherein the second protective element comprises, for the discharge of negative charges, a diode coupled by its cathode to the second circuit node and by its anode to the low voltage terminal.

10. A process according to claim 7, wherein, the integrated electronic circuit comprising a high voltage terminal (Vdd) and a low voltage terminal (Gnd), the first protective element comprises, for the discharge of negative charges, a PMOS transistor whose drain is coupled to the first circuit node and whose grid, source and substrate are connected to the high voltage terminal.

11. A process according to claim 7, wherein, the integrated electronic circuit comprising a high voltage terminal (Vdd) and a low voltage terminal (Gnd), the second protective element comprises a thyristor for the discharge of positive charges towards the low voltage terminal.

12. A process according to any of claims 7, 8 and 9, wherein the first protective element and/or the second protective element comprises, for the discharge of respectively negative or positive charges, a ggNMOS transistor whose drain is coupled to the first circuit node or second circuit node respectively and whose gate, source and substrate are connected to the low voltage terminal.

## Patentansprüche

1. Integrierter elektronischer Schaltkreis (100) umfassend eine Verbindung aus Komponenten, welche ein Netzwerk von Schaltkreisknoten bilden, die durch Zweige des Schaltkreises miteinander verbunden sind, wobei
- wenigstens ein erster Schaltkreisknoten (70) an einen oder mehrere Zweige des Schaltkreises gekoppelt ist, die, wenn der elektronische Schaltkreis keiner operationellen Versorgungsspannung ausgesetzt ist, die Entladung des ersten Knotens nur für elektrische Ladungen einer ersten, positiven oder negativen Polarität, aber nicht für elektrische Ladungen einer zweiten, negativen bzw. positiven Polarität zulassen; und
- wenigstens ein zweiter Schaltkreisknoten (70') an einen oder mehrere Zweige des Schaltkreises gekoppelt ist, die, wenn der elektronische Schaltkreis nicht der operationellen Versorgungsspannung ausgesetzt ist, die Entladung des zweiten Knotens nur für elektrische Ladungen der zweiten Polarität, aber nicht für elektrische Ladungen der ersten Polarität zulassen,
**dadurch gekennzeichnet, dass** der Schaltkreis außerdem umfasst:
- ein erstes Schutzelement (71), welches mit dem ersten Schaltkreisknoten verbunden ist und welches geeignet ist, wenn der elektronische Schaltkreis nicht der operationellen Versorgungsspannung ausgesetzt ist, die Entladung des ersten Schaltkreisknotens für Ladungen der zweiten Polarität zuzulassen, und, wenn der elektronische Schaltkreis der operationellen Versorgungsspannung ausgesetzt ist, das Fließen eines elektrischen Stroms durch das erste Schutzelement hindurch nicht zuzulassen; und
- ein zweites Schutzelement (71'), welches mit dem zweiten Schaltkreisknoten verbunden ist und welches geeignet ist, wenn der elektronische Schaltkreis nicht der operationellen Versorgungsspannung ausgesetzt ist, die Entladung des zweiten Schaltkreisknotens für Ladungen der ersten Polarität zuzulassen, und, wenn der elektronische Schaltkreis der operationellen Versorgungsspannung ausgesetzt ist, das Fließen eines elektrischen Stroms durch das zweite Schutzelement hindurch nicht zuzulassen.

2. Integrierter elektronischer Schaltkreis gemäß Anspruch 1, welcher eine Klemme zur Versorgung mit hoher Spannung (Vdd) und eine Klemme zur Versorgung mit niederer Spannung (Gnd) umfasst, und in welchem das erste Schutzelement für die Entladung der negativen Ladungen eine Diode umfasst, deren Anode an den ersten Schaltkreisknoten gekoppelt ist, und deren Kathode an die Klemme zur Versorgung mit hoher Spannung gekoppelt ist.

3. Integrierter elektronischer Schaltkreis gemäß Anspruch 1 oder Anspruch 2, wobei das zweite Schutzelement für die Entladung der negativen Ladungen eine Diode umfasst, die über ihre Kathode an den zweiten Schaltkreisknoten und über ihre Anode an die Klemme zur Versorgung mit niederer Spannung gekoppelt ist.

4. Integrierter elektronischer Schaltkreis gemäß Anspruch 1, welcher eine Klemme zur Versorgung mit hoher Spannung (Vdd) und eine Klemme zur Versorgung mit niederer Spannung (Gnd) umfasst, und in welchem das erste Schutzelement für die Entladung der negativen Ladungen einen PMOS-Transistor umfasst, dessen Drain-Anschluss an den ersten Schaltkreisknoten gekoppelt ist, und dessen Gitter, Source-Anschluss und Substrat mit der Klemme zur Versorgung mit hoher Spannung verbunden sind.

5. Integrierter elektronischer Schaltkreis gemäß Anspruch 1, welcher eine Klemme zur Versorgung mit hoher Spannung (Vdd) und eine Klemme zur Versorgung mit niederer Spannung (Gnd) umfasst, wobei das zweite Schutzelement einen Thyristor für die Entladung der positiven Ladungen zu der Klemme zur Versorgung mit niederer Spannung hin umfasst.

6. Integrierter elektronischer Schaltkreis nach irgendeinem der Ansprüche 1, 4 und 5, wobei das erste Schutzelement und/oder das zweite Schutzelement für die Entladung der negativen bzw. positiven Ladungen einen ggNMOS-Transistor umfassen, dessen Drain-Anschluss an den ersten Schaltkreisknoten bzw. den zweiten Schaltkreisknoten gekoppelt ist, und dessen Gitter, Source-Anschluss und Substrat mit der Klemme zur Versorgung mit niederer Spannung verbunden sind.

7. Verfahren zur Erstellung eines integrierten elektronischen Schaltkreises, umfassend eine Verbindung aus Komponenten, welche ein Netzwerk von Schaltkreisknoten bilden, die durch Zweige des Schaltkreises miteinander verbunden sind und geeignet sind, eine bestimmte Funktion auszuführen, wenn der elektronische Schaltkreis einer operationellen Versorgungsspannung ausgesetzt ist, wobei das Verfahren durch folgende Schritte **gekennzeichnet** ist:
- Identifizieren wenigstens eines ersten Schaltkreisknotens (70), welcher an einen oder mehrere Zweige des Schaltkreises gekoppelt ist, die, wenn der elektronische Schaltkreis keiner operationellen Versorgungsspannung ausgesetzt ist, die Entladung des ersten Knotens nur für elektrische Ladungen einer ersten, positiven oder negativen Polarität, aber nicht für elektrische Ladungen einer zweiten, negativen bzw. positiven Polarität zulassen; und
- Identifizieren wenigstens eines zweiten Schaltkreisknotens (70'), der an einen oder mehrere Zweige des Schaltkreises gekoppelt ist, die, wenn der elektronische Schaltkreis nicht der operationellen Versorgungsspannung ausgesetzt ist, die Entladung des zweiten Knotens nur für elektrische Ladungen der zweiten Polarität, aber nicht für elektrische Ladungen der ersten Polarität zulassen,
- Zufügen eines ersten Schutzelements (71), welches mit dem ersten Schaltkreisknoten verbunden ist und welches geeignet ist, wenn der elektronische Schaltkreis nicht der operationellen Versorgungsspannung ausgesetzt ist, die Entladung des ersten Schaltkreisknotens für Ladungen der zweiten Polarität zuzulassen, und, wenn der elektronische Schaltkreis der operationellen Versorgungsspannung ausgesetzt ist, das Fließen eines elektrischen Stroms durch das erste Schutzelement hindurch nicht zuzulassen; und
- Zufügen eines zweiten Schutzelements (71'), welches mit dem zweiten Schaltkreisknoten verbunden ist und welches geeignet ist, wenn der elektronische Schaltkreis nicht der operationellen Versorgungsspannung ausgesetzt ist, die Entladung des zweiten Schaltkreisknotens für Ladungen der ersten Polarität zuzulassen, und, wenn der elektronische Schaltkreis der operationellen Versorgungsspannung ausgesetzt ist, das Fließen eines elektrischen Stroms durch das zweite Schutzelement hindurch nicht zuzulassen.

8. Verfahren gemäß Anspruch 1, wobei der integrierte elektronische Schaltkreis eine Klemme zur Versorgung mit hoher Spannung (Vdd) und eine Klemme zur Versorgung mit niederer Spannung (Gnd) umfasst, und wobei das erste Schutzelement für die Entladung der negativen Ladungen eine Diode umfasst, deren Anode an den ersten Schaltkreisknoten gekoppelt ist, und deren Kathode an die Klemme zur Versorgung mit hoher Spannung gekoppelt ist.

9. Verfahren gemäß Anspruch 7 oder Anspruch 8, wobei das zweite Schutzelement für die Entladung der negativen Ladungen eine Diode umfasst, die über ihre Kathode an den zweiten Schaltkreisknoten und über ihre Anode an die Klemme zur Versorgung mit niederer Spannung gekoppelt ist.

10. Verfahren gemäß Anspruch 7, wobei der integrierte elektronische Schaltkreis eine Klemme zur Versorgung mit hoher Spannung (Vdd) und eine Klemme zur Versorgung mit niederer Spannung (Gnd) umfasst, und wobei das erste Schutzelement für die Entladung der negativen Ladungen einen PMOS-Transistor umfasst, dessen Drain-Anschluss an den ersten Schaltkreisknoten gekoppelt ist, und dessen Gitter, Source-Anschluss und Substrat mit der Klemme zur Versorgung mit hoher Spannung verbunden sind.

11. Verfahren gemäß Anspruch 7, wobei der integrierte elektronische Schaltkreis eine Klemme zur Versorgung mit hoher Spannung (Vdd) und eine Klemme zur Versorgung mit niederer Spannung (Gnd) umfasst, wobei das zweite Schutzelement einen Thyristor für die Entladung der positiven Ladungen zu der Klemme zur Versorgung mit niederer Spannung hin umfasst.

12. Verfahren gemäß irgendeinem der Ansprüche 7, 8 und 9, wobei das erste Schutzelement und/oder das zweite Schutzelement für die Entladung der negativen Ladungen bzw. positiven Ladungen einen ggNMOS-Transistor umfassen, dessen Drain-Anschluss an den ersten Schaltkreisknoten bzw. den zweiten Schaltkreisknoten gekoppelt ist, und dessen Gitter, Source-Anschluss und Substrat mit der Klemme zur Versorgung mit niederer Spannung verbunden sind.
